# FASCICULE DE BREVET EUROPEEN

(11) **EP 0 673 068 B1**
(45) Date de publication et mention de la délivrance du brevet: **24.07.2002**
(21) Numéro de dépôt: 95410014.5
(22) Date de dépôt: 10.03.1995
(51) Int. Cl.: H01L 27/02

(54) **Dispositif de protection contre des surtensions dans des circuits intégrés**
Schutzeinrichtung gegen Überspannungen in integrierten Schaltungen
Overvoltage protection device in integrated circuits

(30) Priorité: 14.03.1994 FR 9403302
(43) Date de publication de la demande: 20.09.1995
(73) Titulaire: STMicroelectronics S.A., 92120 Montrouge (FR)
(72) Inventeur: Kalnitsky, Alexander, F-38000 Grenoble (FR)
(74) Mandataire: de Beaumont, Michel

(56) Documents cités:
- US-A- 4 736 271
- INSTITUTE OF ELECTRICAL AND ELECTRONICS ENGINEERS; 11TH ANNUAL PROCEEDINGS RELIABILITY PHYSICS; NEW YORK, Avril 1973, LAS VEGAS, NEVADA, USA pages 198 - 202 L. W. LINHOLM AND AL. 'ELECTROSTATIC GATE PROTECTION USING AN ARC GAP DEVICE'
- PATENT ABSTRACTS OF JAPAN vol. 9, no. 154 (E-325) 28 Juin 1985 & JP-A-60 034 053 (NIPPON DENKI) 21 Février 1985
- PATENT ABSTRACTS OF JAPAN vol. 10, no. 384 (E-466) 23 Décembre 1986 & JP-A-61 174 727 (TOSHIBA) 6 Août 1986
- PATENT ABSTRACTS OF JAPAN vol. 011, no. 113 (E-497) 09 Avril 1987 & JP 61 260 665 A (NEC CORP) 18 Novembre 1986

## Description

La présente invention concerne le domaine des circuits intégrés à semiconducteur.

Les circuits intégrés à semiconducteur sont susceptibles d'être endommagés par des hautes tensions (par exemple des décharges électrostatiques) qui peuvent être appliquées accidentellement à des connecteurs d'entrée et de sortie pendant ou après la fabrication, par exemple tandis qu'on réalise une prise et un positionnement de puce, une liaison par fil au cours du processus d'encapsulation ou positionnement d'un circuit encapsulé dans une embase. Les risques sont par exemple dus à l'application d'une charge électrostatique sur une borne tandis que celle-ci n'est pas protégée, par exemple par une feuille support en matière plastique, à une décharge électrique à partir de pointes d'une machine de liaison et à une décharge due à des opérateurs humains, respectivement. Les dispositifs à semiconducteur fabriqués en technologie MOS (métal-oxyde-semiconducteur) sont particulièrement sensibles à l'application d'une tension élevée sur leur couche d'oxyde de grille.

On inclut dans de nombreux circuits intégrés des structures de protection qui deviennent conductrices au-dessus d'une certaine tension de seuil et qui éliminent les surcharges électrostatiques appliquées au circuit, par exemple vers le potentiel de la masse. Ces structures doivent revenir à un état non-conducteur après application de la surcharge électrostatique. Ces structures sont habituellement constituées de diodes à avalanche intégrées connectées aux plots d'entrée et de sortie.

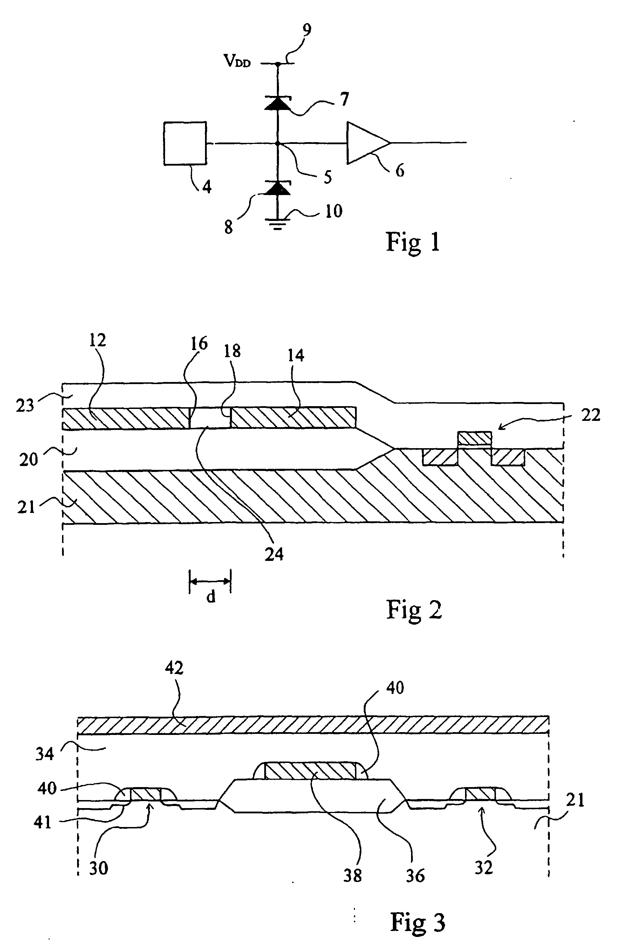

La figure 1 représente un circuit utilisant des dispositifs de protection connus contre des surtensions. Une borne d'entrée 4 est connectée par un noeud 5 au circuit 6 à protéger et également à des premières bornes de première et deuxième diodes à avalanche de protection 7 et 8. La deuxième borne de la première diode de protection 7 est connectée à une borne d'alimentation 9 au potentiel d'alimentation V_{DD}. La deuxième borne de la deuxième diode de protection 8 est connectée à la masse 10. Dans le schéma, les diodes sont représentées avec une orientation correcte pour une tension d'alimentation V_{DD} positive. Leurs cathodes sont normalement connectées à une tension plus positive que leurs anodes. Ces diodes sont donc normalement non-conductrices. Toutefois, comme dans tout dispositif semiconducteur, il circule un faible courant de fuite inverse dont l'amplitude dépend de la surface de jonction de la diode et des niveaux de dopage des matériaux semiconducteurs de part et d'autre de la jonction.

Si une surtension positive est appliquée à la borne d'entrée 4, la diode 7 se polarise en direct et devient conductrice et la haute tension est reliée à la tension V_{DD}, évitant tout endommagement du circuit 6. Si la surtension est suffisamment élevée, la tension d'avalanche du dispositif de protection 8 sera atteinte et celui-ci devient également conducteur et reliera la surtension à la masse 10.

Si une surtension négative élevée est appliquée à la borne d'entrée 4, la diode à avalanche de protection 8 est polarisée en direct et devient conductrice. Ainsi, la surtension est reliée à la masse et empêche tout endommagement du circuit 6. Si la surtension est suffisamment négative, la tension d'avalanche du dispositif de protection 7 sera atteinte et celui-ci deviendra conducteur et reliera la surtension à la tension V_{DD}.

De tels dispositifs de protection à diode présentent de nombreux inconvénients. Ils occupent une grande surface liée à la capacité de dissipation élevée de puissance requise. Ils laissent également passer un certain courant de fuite, même aux tensions de fonctionnement normales, ce qui contribue de façon non-nécessaire à la consommation de courant du circuit intégré. Le courant de fuite de ces diodes dans des conditions normales de fonctionnement peut augmenter par suite de surcharges électriques. De plus, ces courants de fuite ont tendance à augmenter quand les diodes ont été soumises à plusieurs claquages. Les diodes à avalanche mettent un certain temps à entrer en conduction. Si une surtension croît rapidement, les diodes peuvent n'entrer en conduction qu'après un endommagement du circuit à protéger. La tension d'avalanche étant déterminée par les niveaux de dopage du semiconducteur de part et d'autre de la jonction de la diode de protection, pour atteindre la tension d'avalanche requise, des étapes de fabrication particulières peuvent devoir être incluses dans le processus de fabrication du circuit intégré, ce qui augmente les coûts de fabrication, ou bien les diodes à avalanche peuvent être formées en utilisant des niveaux de dopage déjà prévus dans le processus de fabrication des transistors et autres structures des circuits intégrés, ce qui produit des diodes à avalanche ayant une tension de seuil non-optimale.

On a déjà proposé (L.W. Linholm et al, IEEE Annual Proceedings Reliability Physics, 1973 ; Japanese Patent Application N° 60034053) d'utiliser des structures à espace de décharge dans des dispositifs de protection de circuits intégrés.

Le premier de ces documents utilise deux conducteurs définis dans une même couche métallique formée sur une couche isolante et séparés par une fente définie par photolithographie. Cette fente définit un espace vide. Comme les conducteurs se trouvent sur une couche isolante, ils sont séparés par une même distance d'isolant et d'air. Le matériau isolant est donc affecté par l'application de tensions élevées entre les conducteurs. En outre, la fente a une largeur minimale définie par la dimension minimale du processus lithographique. Cette dimension est par exemple de 500 nm. Le dispositif décrit devient alors conducteur pour une tension supérieure à 300 V, et n'assure donc pas une protection utile à des circuits intégrés qui peuvent être endommagés par des tensions de l'ordre de 15 V.

Le second document propose une structure en sandwich de deux conducteurs séparés par une région diélectrique. Une partie du diélectrique entre les deux conducteurs est éliminée par gravure pour définir un espace vide. Une autre couche de diélectrique est formée sur la structure résultante, sans remplir l'espace vide, pour former une cavité remplie de gaz.

Les deux structures décrites ci-dessus comportent l'agencement en parallèle d'un espace vide et d'un espace rempli de diélectrique, ayant les mêmes longueurs entre les deux conducteurs. Une telle structure peut entraîner un claquage destructif du diélectrique, en particulier à ses bords, d'où il résulte que la protection sera moins efficace après une ou plusieurs applications d'une tension élevée à la structure.

En outre, le second document suggère l'utilisation d'un espace vide en parallèle avec une couche d'oxyde de grille d'un circuit intégré. Or, c'est souvent cette couche d'oxyde de grille que l'on cherche à protéger contre une surtension.

Un objet de la présente invention est de prévoir un dispositif de protection contre les surtensions de dimensions minimales à l'intérieur d'un circuit intégré.

Un autre objet de la présente invention est de prévoir un tel dispositif qui puisse être fabriqué par des étapes sensiblement telles qu'utilisées dans un processus de fabrication standard de circuit intégré.

Un autre objet de la présente invention est de prévoir un tel dispositif qui devienne conducteur suffisamment vite et à des tensions suffisamment faibles pour ne provoquer aucun endommagement du circuit à protéger avant que le dispositif de protection ne devienne conducteur.

Un autre objet de la présente invention est de prévoir un tel dispositif qui ne laisse pas passer de courant de fuite dans les conditions normales de fonctionnement.

Un autre objet de la présente invention est de prévoir un tel dispositif de tension de claquage prédéterminable et répétitive.

Un autre objet de la présente invention est de prévoir un tel dispositif qui soit également efficace pour assurer une protection à l'encontre de surtensions positive et négative sur les plots d'entrée ou de sortie. Un autre type de composant semiconducteur est décrit dans JP 61260665.

Pour atteindre ces objets, la présente invention telle que revendiquée dans la revendication 1 prévoit une structure formée dans un circuit intégré, comprenant au moins deux éléments conducteurs ayant des faces en regard, séparées par un intervalle rempli d'un gaz qui s'étend latéralement au-delà de la petite des faces en regard.

Selon un mode de réalisation de la présente invention, cette structure comprend des moyens de connexion respectivement reliés à chacun des éléments conducteurs et à des points du circuit intégré entre lesquels une protection contre une surtension est souhaitée.

Selon un mode de réalisation de la présente invention, ledit intervalle correspond à une cavité délimitée par les deux éléments conducteurs et au moins un matériau non-conducteur.

Selon un mode de réalisation de la présente invention, l'intervalle entre les deux éléments conducteurs a une longueur comprise entre 10 et 90 nm.

Selon un mode de réalisation de la présente invention, au moins un des éléments conducteurs est du tungstène.

Selon un mode de réalisation de la présente invention, les éléments conducteurs sont en des matériaux distincts.

Selon un mode de réalisation de la présente invention, le premier élément conducteur est une colonne d'un premier matériau conducteur portée par sa base et située au-dessus d'un substrat semiconducteur ; et le second élément conducteur est un conducteur d'un deuxième matériau conducteur séparé de la colonne par un intervalle rempli de gaz, ce second élément ayant une face en regard d'une partie de la périphérie de la colonne et s'étendant en face d'une partie seulement de la hauteur de la colonne.

Selon un mode de réalisation de la présente invention, la colonne est portée par sa base sur une ou plusieurs couches de matériau conducteur, par exemple du silicium polycristallin.

Selon un mode de réalisation de la présente invention, la connexion électrique vers la colonne est assurée par une couche de connexion en matériau conducteur, par exemple de l'aluminium, déposée sur la surface supérieure de la colonne, la surface inférieure de cette couche de connexion faisant partie de la surface interne de ladite cavité.

Un procédé de fabrication d'une structure selon l'invention telle que revendiquée dans la revendication 16 comprend les étapes consistant à prévoir un substrat comprenant une première couche de matériau isolant sur sa face supérieure ; déposer une couche d'un premier matériau conducteur sur la surface supérieure de la première couche de matériau isolant ; graver une première ouverture dans le premier matériau conducteur ; déposer une deuxième couche de matériau isolant pour recouvrir la surface supérieure du premier matériau conducteur et remplir la première ouverture ; graver une deuxième ouverture dans la deuxième couche de matériau isolant, la deuxième ouverture recouvrant toute la surface de la première ouverture ; graver une troisième ouverture dans la première couche de matériau isolant directement sous la première ouverture ; recouvrir toute la surface de la structure, y compris les surfaces internes des ouvertures, d'une couche mince de matériau ; remplir les ouvertures d'un deuxième matériau conducteur ; graver la couche mince de matériau jusqu'à ce que sa surface supérieure soit située en dessous de la surface inférieure de la première couche de matériau conducteur ; et déposer une couche de scellement sur la surface de la structure sans que le matériau de cette couche ne remplisse la partie gravée de la couche mince.

Selon un mode de réalisation de la présente invention, ce procédé comprend en outre l'étape consistant à déposer sous la première couche de matériau isolant une troisième couche, par exemple en silicium polycristallin, par rapport à laquelle les première et deuxième couches de matériau isolant sont gravables sélectivement.

Ces objets, caractéristiques et avantages ainsi que d'autres de la présente invention seront exposés en détail dans la description suivante de modes de réalisation particuliers faite, à titre non limitatif, en relation avec les figures jointes parmi lesquelles :
la figure 1 est un schéma de circuit illustrant l'utilisation de dispositifs classiques de protection d'entrée ou de sortie ;
la figure 2 représente la structure d'un mode de réalisation d'un dispositif de protection contre des surtensions ;
les figures 3 à 8 représentent des étapes successives d'un procédé de fabrication d'un mode de réalisation d'un dispositif selon la présente invention ; et
la figure 9 représente une vue de dessus du dispositif de protection de la figure 8.

La figure 2 représente de façon générale une structure qui ne fait pas partie de l'invention revendiquée. Deux électrodes 12 et 14 présentent des faces en regard respectives 16 et 18 séparées d'une très faible distance d. Les deux électrodes sont disposées sur une couche électriquement isolante 20. La couche 20 est elle-même formée sur un substrat semiconducteur 21 qui comprend des dispositifs tels que des transistors de type MOS 22. Une seconde couche électriquement isolante 23 peut être disposée sur les deux électrodes 12, 14 pour définir une cavité 24 vide ou remplie d'un gaz.

Le dispositif de protection contre des surtensions ainsi formé permet d'assurer une protection entre les deux électrodes 12 et 14. L'une de ces électrodes peut être connectée à un plot d'entrée ou de sortie à protéger, l'autre électrode étant connectée à une tension d'alimentation ou à la masse. Quand une surtension survient entre les deux électrodes et que la différence de potentiel dépasse un certain seuil, le gaz dans la cavité 24 devient conducteur et un courant passe entre les électrodes 12 et 14. L'invention vise à protéger un circuit intégré contre l'application de tensions de l'ordre de 15 V. Pour réaliser une protection contre de telles tensions faibles, il faut une longueur de cavité d inférieure à 100 nm, typiquement dans la plage de 10 à 90 nm. Pour de telles petites distances, la tension de claquage dépend essentiellement du matériau et de la rugosité de surface des électrodes et de leur distance d, plutôt que des paramètres du gaz car la décharge dans un gaz pour des électrodes très proches l'une de l'autre ressemble beaucoup à une décharge dans le vide qui ne dépend que des électrodes.

Quand des matériaux distincts sont utilisés pour les deux électrodes, on obtient des tensions de claquage et des caractéristiques de diodes différentes dans chacune des directions. Les tensions de claquage seront Bkv+Δφ dans un sens et Bkv-Δφ dans l'autre sens où Δφ est la différence des potentiels d'extraction des deux matériaux et où Bkv est la moyenne des deux tensions de claquage. La différence des potentiels d'extraction peut aller jusqu'à environ 1,2 V.

Un mode de réalisation particulier d'un dispositif de protection selon la présente invention va maintenant être décrit. Ce mode de réalisation particulier est fabriqué en utilisant un processus complètement compatible avec des techniques courantes de fabrication de circuits intégrés à semiconducteur incluant des vias (trous formés dans une couche isolante entre deux couches conductrices et remplis d'un matériau conducteur).

La figure 3 représente une vue en coupe d'un circuit intégré à semiconducteur formé sur un substrat 21 après réalisation de dispositifs semiconducteurs tels que des transistors MOS 30, 32. Une couche diélectrique 34 est disposée au-dessus des dispositifs semiconducteurs et des régions d'oxyde de champ 36 sont typiquement formées entre des zones séparées du circuit dans des buts d'isolement.

Selon un aspect de l'invention, une couche d'un matériau 38 par rapport auquel le matériau de la couche diélectrique 34 peut être gravé sélectivement est présente sur l'oxyde de champ 36 et sous la couche diélectrique 34 à l'emplacement choisi pour le dispositif de protection. De préférence, la couche diélectrique 34 est en oxyde de silicium et la couche 38 est en silicium polycristallin et est formée en même temps que les couches de grille en silicium polycristallin des transistors 30, 32. Des espaceurs 40 utilisés pour délimiter des régions faiblement dopées 41 dans le semiconducteur peuvent être présents ou non selon le type de technologie utilisé. Une première couche conductrice 42 est déposée sur l'ensemble de la tranche.

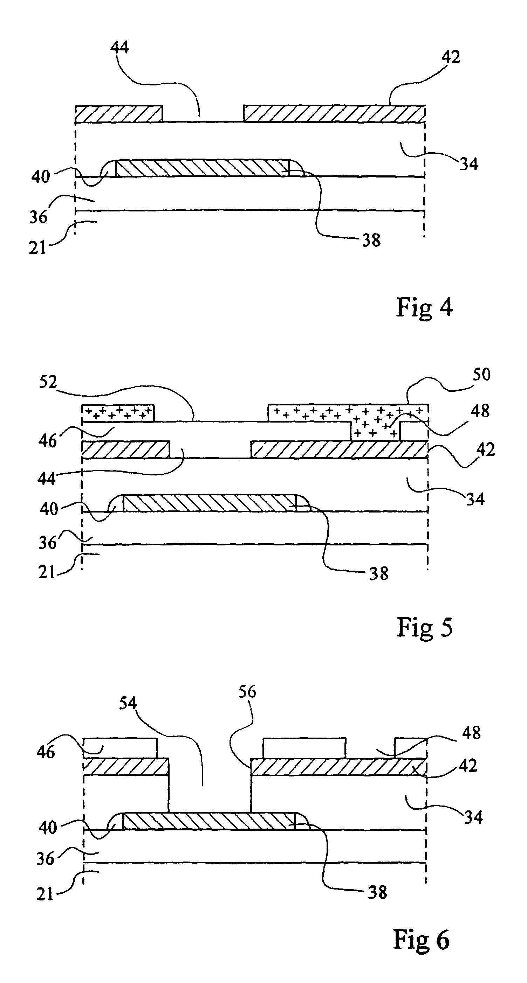

En figure 4 est représentée une ouverture 44 ouverte dans la couche conductrice 42 au-dessus d'une partie de la couche 38 par un procédé de photolithogravure.

Ensuite, comme le représente la figure 5, une seconde couche de matériau diélectrique 46 est appliquée sur l'ensemble de la tranche et planarisée par un procédé classique.

Une autre étape de gravure photolithographique peut être utilisée pour former des ouvertures 48 dans la seconde couche diélectrique à des emplacements où des connexions électriques (vias) seront requises entre la première couche conductrice 42 et une couche conductrice formée ultérieurement. Une couche d'un produit photosensible (résine) 50 est déposée sur toute la surface de la tranche et ouverte pour exposer une région 52 de la deuxième couche diélectrique 46. Selon un aspect de l'invention, la région exposée 52 est plus large que l'ouverture 44 dans la première couche conductrice et la recouvre complètement. Ceci est destiné à tenir compte des tolérances d'alignement de masques.

Une étape de gravure sélective des matériaux diélectriques utilisés est réalisée sur la tranche. La gravure doit être anisotrope et est par exemple une gravure sous plasma de CHF₃ quand les couches diélectriques sont en oxyde de silicium. Selon un aspect de l'invention, cette étape est poursuivie suffisamment longtemps pour graver la seconde couche diélectrique 46 sous la région exposée 52 et la première couche diélectrique 34 sous l'ouverture 44, jusqu'à ce que la gravure atteigne la couche 38. La couche de résine 50 est alors enlevée.

On obtient ainsi la structure de la figure 6. Un trou 54 est ouvert à partir de la surface de la deuxième couche diélectrique 46 jusqu'à la surface supérieure de la couche 38. Une surface latérale 56 de la couche conductrice 42 apparaît à l'intérieur du trou et le trou dans la première couche diélectrique 34 a les dimensions de l'ouverture 44 dans la couche conductrice 42. Le via 48 optionnellement formé dans la deuxième couche diélectrique 46 laisse apparaître la surface de la couche conductrice 42.

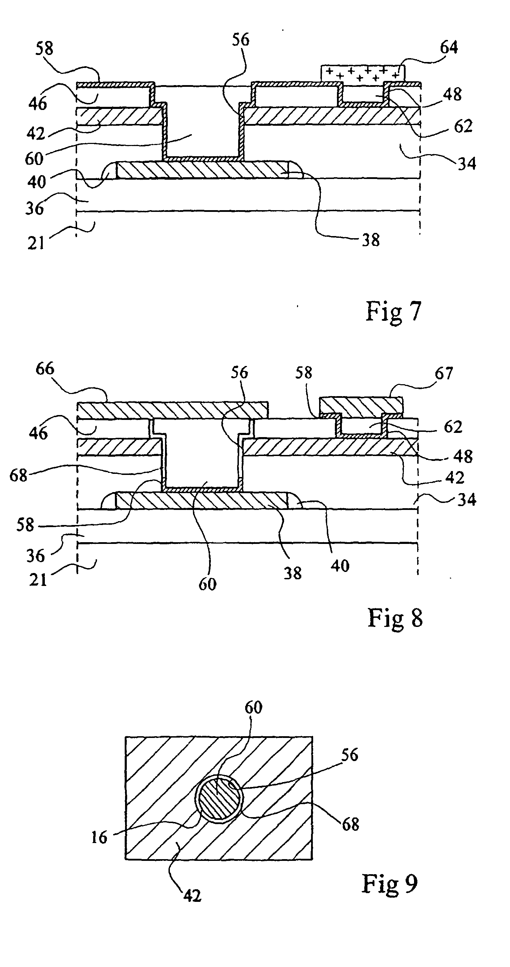

Comme le représente la figure 7, toute la surface de la tranche, y compris les parois et le fond du trou 54, est recouverte d'une couche 58 déposée par voie chimique en phase vapeur. Cette couche doit être mince, conforme à la surface, adhérente et sélectivement gravable par rapport au matériau de la couche 38, des couches diélectriques 34, 36, de la première couche conductrice 42 et du matériau conducteur décrit ci-après. Si, comme cela est représenté en figure 7, des découpes de vias 48 sont prévues, la couche 58 doit également être électriquement conductrice. De préférence, la couche 58 est constituée d'une couche de titane suivie d'une couche de nitrure de titane. La découpe de via 48 et le trou 54 sont alors remplis d'un matériau conducteur pour former une colonne 60 et des vias 62 dont les surfaces supérieures sont sensiblement coplanaires avec la surface supérieure de la deuxième couche diélectrique 46. Ce matériau conducteur peut être du tungstène déposé par voie chimique en phase vapeur selon une épaisseur suffisante pour remplir tous les trous dans la seconde couche diélectrique qui est ensuite gravée sans masque par une gravure sélective du matériau conducteur pendant une durée suffisante pour que la surface de la couche 58 soit apparente aux emplacements autres que ceux où des vias ou des dispositifs selon l'invention doivent être formés. Une gravure sous plasma au fluor peut être utilisée si le matériau conducteur est du tungstène et que le matériau de la couche 58 est du titane/nitrure de titane.

Un masque de résine 64 est alors placé sur les vias. Une gravure sélective du matériau de la couche 58, par exemple par un plasma contenant du chlore pour une couche 58 en titane/nitrure de titane, est réalisée sur la tranche. Cette gravure se poursuit suffisamment longtemps pour enlever la couche 58 presque jusqu'au fond du trou. Une quantité minimale de matériau de la couche 58 doit rester en place pour maintenir la colonne 60, mais la couche 58 doit être gravée suffisamment profond sous la surface inférieure de la première couche conductrice 42. L'enlèvement de la couche 58 entraîne qu'un espace vide se forme entre la colonne 60 et une partie de la première couche conductrice 42. Le bord de la première couche conductrice 42 et une partie opposée de la surface de la colonne 60 constituent des faces en regard et l'espace vide s'étend latéralement au-delà des bords de la plus petite de ces deux faces en regard, ici les bords de la couche 42. Il n'y a pas de matériau diélectrique entre les deux faces en regard, ni dans l'espace voisin de la plus petite de ces faces. Il n'y a donc pas de connexion en parallèle d'un espace rempli de gaz et d'un espace rempli de diélectrique de longueurs identiques.

Le produit de gravure doit être choisi avec soin pour obtenir la sélectivité nécessaire entre le matériau de la couche adhésive 58 et le matériau de la colonne 60 et des autres éléments concernés.

La figure 8 représente la tranche après enlèvement du masque 64 et application d'une deuxième couche conductrice sur toute la surface de la tranche, cette couche conductrice étant gravée par photolithogravure. Après cette étape de photolithogravure, deux parties 66 et 67 de la deuxième couche conductrice restent en place, au-dessus de la colonne 60 et des vias 62, respectivement. Le dépôt de la deuxième couche semiconductrice obture la cavité 68 qui résulte de l'enlèvement de la couche 58. La cavité 68 s'étend latéralement au-delà des bords de la première couche conductrice et contient des gaz dont la nature et la pression résultent du dépôt de la deuxième couche conductrice. Cette pression peut être d'environ 10⁻⁷ à 10⁻³ torr (1,3x10⁻⁵ à 1,3x10⁻¹ Pa). Comme cela a été exposé précédemment, le type et la pression de ce gaz ont peu d'influence sur le fonctionnement du dispositif selon l'invention. La première partie 66 de la deuxième couche conductrice est en contact électrique avec la colonne 60 et la deuxième partie 67 de la deuxième couche conductrice est en contact avec la première couche conductrice par l'intermédiaire des vias 62. La deuxième couche conductrice peut être en aluminium, en un alliage d'aluminium ou en tout matériau conducteur d'interconnexion utilisé dans le domaine des circuits intégrés.

La figure 9 représente une vue de dessus de la structure de la figure 8 au niveau de la première couche conductrice 42. La dimension de la colonne 60 peut correspondre à la dimension de via minimale possible dans la technologie utilisée. La première face en regard, la surface 56 de la première couche conductrice 42, est donc annulaire et la seconde face en regard, la surface 16 de la colonne 60, est cylindrique. L'espace 68 s'étend en dehors du plan du dessin, au-dessus et en-dessous de la première couche conductrice 42.

La séparation des surfaces d'électrodes en regard 56, 16 est égale à l'épaisseur de la couche 58 telle que déposée et peut en conséquence être déterminée par des paramètres technologiques classiques. Cette épaisseur est par exemple de 10 à 90 nm, ce qui est bien inférieur à la distance minimale qui pourrait être produite par des étapes de photolithogravure dans une technologie classique de fabrication de semiconducteur.

La structure selon l'invention permet une protection contre des surtensions entre la colonne 60 et la première couche conductrice 42. Dans le mode de réalisation illustré, la connexion électrique entre la structure selon l'invention et le circuit à protéger est réalisée en utilisant les éléments 66, 67 de la seconde couche conductrice et les vias 62.

En se référant à la figure 1, on peut utiliser la structure selon l'invention comme dispositif de protection 8 contre des surtensions, le dispositif selon l'invention étant connecté entre le noeud 5 et la masse 10. Comme le dispositif de protection selon l'invention est également efficace pour des surtensions positive et négative, il n'est pas nécessaire de prévoir un deuxième dispositif de protection 7.

Un dispositif selon l'invention dans lequel l'intervalle entre électrodes est de l'ordre de 20 nm aura une tension de claquage d'environ 10 V, selon le matériau et la qualité de surface des électrodes. La tension de claquage du dispositif peut être déterminée par le choix de l'épaisseur de la couche 58.

Le dispositif selon la présente invention présente l'avantage de ne pas présenter de courants de fuite aux tensions de fonctionnement normales même si des surtensions répétées sont appliquées au plot d'entrée/sortie. A des tensions de fonctionnement normal, aucun courant ne passera dans la structure selon l'invention. Le dispositif occupe une très petite surface : la colonne 60 présente en vue de dessus une surface de l'ordre de 1µm² dans une technologie classique, l'ensemble de la structure occupant une surface d'environ 10µm².

Bien qu'un mode de réalisation particulier de l'invention ait été décrit en détail, de nombreuses variantes apparaîtront à l'homme de l'art. La couche 38 peut être utilisée comme conducteur d'accès à la colonne 60, une couche non-conductrice étant déposée pour sceller la cavité 68. D'autres couches conductrices peuvent être prévues entre les première (42) et seconde (66, 67) couches conductrices pour former un dispositif de protection à plus de deux bornes. La première couche conductrice 42 peut être conformée pour présenter une pluralité de surfaces isolées dans la cavité 68, pour produire à nouveau un dispositif de protection à plus de deux bornes. On pourra utiliser des matériaux distincts pour les deux électrodes 12 et 14 pour produire un dispositif ayant une caractéristique de diode souhaitée sans courant, de fuite et endommagement éventuel associée aux diodes à semiconducteur soumises à des tensions de borne élevées. La couche 38 peut être omise et la gravure de la couche mince 58 contrôlée par la durée de l'étape de gravure pour former un trou 54 de profondeur requise. La structure selon l'invention, s'applique aussi à des domaines autres que la protection, par exemple à un dispositif à seuil ou un générateur de dents de scie où une charge s'accumule de façon cyclique sur une électrode jusqu'à ce qu'elle soit déchargée par la structure.

## Revendications

1. Structure de protection contre les surtensions formée dans un circuit intégré, **caractérisée en ce qu'**elle comprend :
une colonne (60) constituée d'un premier matériau conducteur portée par sa base et située au-dessus d'un substrat semiconducteur (21) ; et
un conducteur (42) constitué d'un deuxième matériau conducteur séparé de la colonne par un intervalle rempli de gaz (68), ayant une face en regard d'une partie de la périphérie de la colonne et s'étendant en face d'une partie seulement de la hauteur de la colonne ledit intervalle s'étendant au-delà de ladite face en regard .

2. Structure selon la revendication 1, **caractérisée en ce qu'**elle comprend des moyens de connexion (66, 67) respectivement reliés à chacun des matériaux conducteurs (60, 42) et à des points du circuit intégré entre lesquels une protection contre une surtension est souhaitée.

3. Structure selon la revendication 1, dans laquelle ledit intervalle est contenu dans une cavité (68) délimitée par les deux matériaux conducteurs (60, 42) et au moins un matériau non-conducteur (36, 34, 46).

4. Structure selon la revendication 1, dans laquelle ledit intervalle a une longueur comprise entre 10 et 90 nm.

5. Structure selon la revendication 1, dans laquelle au moins un des matériaux conducteurs (60, 42) est du tungstène.

6. Structure selon la revendication 1, dans laquelle les matériaux conducteurs (60, 42) sont distincts.

7. Structure selon la revendication 3, dans laquelle au moins un desdits matériaux non-conducteurs (36, 34, 46) comprend du dioxyde de silicium.

8. Structure selon la revendication 1, dans laquelle la colonne (60) est portée par sa base sur une ou plusieurs couches de matériau conducteur (38, 58).

9. Structure selon la revendication 8, dans laquelle la couche de matériau conducteur support (38) est en silicium polycristallin.

10. Structure selon la revendication 8, dans laquelle la couche de matériau conducteur support comprend du titane.

11. Structure selon la revendication 8, dans laquelle la couche de matériau conducteur support (58) comprend du nitrure de titane.

12. Structure selon la revendication 1, dans laquelle la connexion électrique vers la colonne (60) est assurée par une couche de connexion en matériau conducteur (66) déposée sur la surface supérieure de la colonne, la surface inférieure de cette couche de connexion faisant partie de la surface interne de ladite cavité (24 ; 68).

13. Structure selon la revendication 12, dans laquelle la couche de connexion (66) est une couche comprenant de l'aluminium.

14. Structure selon la revendication 1, dans laquelle la colonne (60) repose sur une couche mince (58) d'épaisseur égale à la longueur de l'intervalle (68).

15. Structure selon la revendication 14, dans laquelle ladite couche mince (58) a une épaisseur comprise entre 10 et 90 nm.

16. Procédé de fabrication d'une structure selon la revendication 1, **caractérisé en ce qu'**il comprend les étapes suivantes :
prévoir un substrat (21) comprenant une première couche de matériau isolant (34) sur sa face supérieure ;
déposer une couche d'un premier matériau conducteur (42) sur la surface supérieure de la première couche de matériau isolant ;
graver une première ouverture (44) dans le premier matériau conducteur (42) ;
déposer une deuxième couche de matériau isolant (46) pour recouvrir la surface supérieure du premier matériau conducteur (42) et remplir la première ouverture ;
graver une deuxième ouverture dans la deuxième couche de matériau isolant (46), la deuxième ouverture recouvrant toute la surface de la première ouverture (44) ;
graver une troisième ouverture dans la première couche de matériau isolant (34) directement sous la première ouverture (44) ;
recouvrir toute la surface de la structure, y compris les surfaces internes des ouvertures, d'une couche mince (58) de matériau ;
remplir les ouvertures d'un deuxième matériau conducteur (60) ;
graver la couche mince (58) de matériau jusqu'à ce que sa surface supérieure soit située en dessous de la surface inférieure de la première couche de matériau conducteur (42) ; et
déposer une couche de scellement (66) sur la surface de la structure sans que le matériau de cette couche ne remplisse la partie gravée de la couche mince (58).

17. Procédé selon la revendication 16, comprenant en outre l'étape consistant à déposer sous la première couche de matériau isolant (34) une troisième couche (38) par rapport à laquelle les première et deuxième couches de matériau isolant sont gravables sélectivement.

18. Procédé selon la revendication 17, dans lequel la troisième couche (38) est en silicium polycristallin.

19. Procédé selon la revendication 16, dans lequel la couche mince (58) a une épaisseur comprise entre 10 nm et 90 nm.

20. Procédé selon la revendication 19, dans lequel la couche mince (58) est une couche composite de titane et de nitrure de titane.

## Patentansprüche

1. Eine Überspannungsschutzstruktur ausgebildet innerhalb einer integrierten Schaltung, **dadurch gekennzeichnet, daß** diese folgendes aufweist:
eine Säule (60) aus einem ersten leitenden Material getragen an einer Basis und angeordnet über einem Halbleitersubstrat (21), und
einen Leiter (42) mit entgegengesetzt liegenden Stirnflächen entgegengesetzt zu einem Teil des Umfangs der Säule, und sich entgegengesetzt nur über einen Teil der Höhe der Säule erstreckend, und zwar ein zweites leitendes Material aufweisend getrennt von der Säule durch einen gasgefüllten Spalt (68), wobei sich der Spalt über die erwähnte entgegengesetzte Stirnfläche erstreckt.

2. Die Struktur nach Anspruch 1, **dadurch gekennzeichnet, daß** sie jeweils Verbindungsmittel (66, 67) aufweist, und zwar verbunden mit jedem der erwähnten mindestens zwei leitenden Materialien (60, 42) und mit Punkten der integrierten Schaltung, zwischen denen ein Überspannungsschutz erwünscht ist.

3. Die Struktur nach Anspruch 1, wobei der Spalt in einem Hohlraum (68) enthalten ist, und zwar definiert durch die zwei leitenden Materialien (60, 42) und mindestens ein nicht leitendes Material (36, 34, 46).

4. Die Struktur nach Anspruch 1, wobei der gasgefüllte Spalt eine Länge im Bereich zwischen 10 nm und 90 nm besitzt.

5. Die Struktur nach Anspruch 1, wobei mindestens eines der mindestens zwei leitenden Materialien (60, 42) Wolfram ist.

6. Die Struktur nach Anspruch 1, wobei die leitenden Materialien (60, 42) gegenseitig unterschiedlich sind.

7. Die Struktur nach Anspruch 3, wobei mindestens eines der nicht leitenden Materialien (36, 34, 46) Siliziumdioxid umfaßt.

8. Die Struktur nach Anspruch 1, wobei die Säule (60) an der Basis durch mindestens eine Schicht eines leitenden Materials (38, 58) getragen wird.

9. Die Struktur nach Anspruch 8, wobei die Schicht des tragenden leitenden Materials (38) aus Polysilizium hergestellt ist.

10. Die Struktur nach Anspruch 8, wobei die Schicht des tragenden leitenden Materials Titan aufweist.

11. Die Struktur nach Anspruch 8, wobei die Schicht des tragenden leitenden Materials (58) Titannitrid aufweist.

12. Die Struktur nach Anspruch 1, wobei eine elektrische Verbindung mit der Säule (60) vorgesehen ist, und zwar durch eine Verbindungsschicht eines leitenden Materials (66) abgeschieden auf einer Oberseite (oder obere Oberfläche) der Säule, wobei eine untere Oberfläche (Unterseite) der Verbindungsschicht einen Teil einer Innenoberfläche des erwähnten Hohlraums (24; 68) bildet.

13. Die Struktur nach Anspruch 12, wobei die Verbindungsschicht (66) eine Schicht ist, die im wesentlichen aus Aluminium besteht.

14. Die Struktur nach Anspruch 1, wobei die Säule (60) auf einer dünnen Schicht (58) getragen wird mit einer Dicke gleich der Länge des Spaltes (68).

15. Die Struktur nach Anspruch 14, wobei die Dicke der dünnen Schicht (58) in einem Bereich zwischen 10 nm und 90 nm liegt.

16. Ein Verfahren zur Herstellung von einer Struktur nach Anspruch 1, **dadurch gekennzeichnet, daß** folgende Schritte vorgesehen sind:
Vorsehen eines Substrats (21) einschließlich einer ersten Schicht aus Isoliermaterial (34) auf einer Oberseite;
Abscheiden einer Schicht eines ersten leitenden Materials (42) auf einer Oberseite der ersten Schicht aus Isoliermaterial;
Ätzen einer ersten Öffnung (44) in dem ersten leitenden Material (42);
Abscheiden einer zweiten Schicht aus Isoliermaterial (46) zur Abdeckung einer Oberseite des ersten leitenden Materials (42) und zum Füllen der ersten Öffnung;
Ätzen einer zweiten Öffnung in der zweiten Schicht aus Isoliermaterial (46), wobei die zweite Öffnung die Oberfläche der ersten Öffnung (44) abdeckt;
Ätzen einer dritten Öffnung in der ersten Schicht aus Isoliermaterial (34) direkt unterhalb der ersten Öffnung (44);
Abscheiden einer dünnen Schicht (58) aus Material über einer Oberseite der Struktur einschließlich der Innenoberflächen der Öffnungen;
Füllen der Öffnungen mit einem zweiten leitenden Material (60);
Ätzen der dünnen Materialschicht (58), bis ihre Oberfläche unter einer Unterseite der Schicht aus ersten leitendem Material (42) angeordnet ist; und
Abscheiden einer Dicht- oder Versiegelungsschicht (66) über der Struktur, wobei die Dicht- oder Versiegelungsschicht nicht den geätzten Teil der dünnen Schicht (58) einnimmt.

17. Verfahren nach Anspruch 16, wobei ferner ein Schritt des Abscheidens einer dritten Schicht (38) unterhalb der ersten Schicht aus Isoliermaterial (34) vorgesehen ist, wobei die dritte Schicht (38) die Überspannungsschutzstruktur trägt und wobei die erste und zweite Schicht aus Isoliermaterial selektiv bezüglich der erwähnten dritten Schicht ätzbar sind.

18. Das Verfahren nach Anspruch 17, wobei die dritte Schicht (38) aus Polysilizium hergestellt ist.

19. Das Verfahren nach Anspruch 16, wobei die dünne Schicht (58) eine Dicke im Bereich zwischen 10 nm und 90 nm besitzt.

20. Das Verfahren nach Anspruch 19, wobei die dünne Schicht (58) eine Kompositschicht aus Titan und Titannitrid ist.

## Claims

1. An overvoltage protection structure formed within an integrated circuit, **characterized in that** it comprises:
a column (60) comprised of a first conductive material, supported at a base and disposed over a semiconductor substrate (21), and
a conductor (42) having an opposing face opposite a part of the periphery of the column, and extending opposite only a part of a height of the column, comprised of a second conductive material, separated from the column by a gas filled gap (68), said gap extending beyond said opposing face.

2. The structure according to claim 1, **characterized in that** it comprises connection means (66, 67) respectively connected to each of said at least two conductive materials (60, 42) and to points of the integrated circuit between which an overvoltage protection is desired.

3. The structure according to claim 1, wherein said gap is contained in a cavity (68) defined by the two conductive materials (60, 42) and at least one non-conductive material (36, 34, 46).

4. The structure according to claim 1, wherein the gas filled gap has a length in a range between 10 nm and 90 nm.

5. The structure according to claim 1, wherein at least one of the at least two conductive materials (60, 42) is tungsten.

6. The structure according to claim 1, wherein the conductive materials (60, 42) are mutually different.

7. The structure according to claim 3, wherein at least one of said non-conductive materials (36, 34, 46) includes silicon dioxide.

8. The structure according to claim 1, wherein the column (60) is supported at the base by at least one layer of a conductive material (38, 58).

9. The structure according to claim 8, wherein the layer of supporting conductive material (38) is made of polysilicon.

10. The structure according to claim 8, wherein the layer of supporting conductive material includes titanium.

11. The structure according to claim 8, wherein the layer of supporting conductive material (58) includes titanium nitride.

12. The structure according to claim 1, wherein an electrical connection to the column (60) is provided by a connection layer of a conductive material (66) deposited onto an upper surface of the column, a lower surface of said connection layer forming a part of an inner surface of said cavity (24; 68).

13. The structure according to claim 12, wherein the connection layer (66) is a layer substantially composed of aluminum.

14. The structure according to claim 1, wherein the column (60) is supported on a thin layer (58) having a thickness equal to a length of the gap (68).

15. The structure according to claim 14, wherein the thickness of said thin layer (58) is in a range between 10 nm and 90 nm.

16. A method for manufacture of a structure according to claim 1, **characterized in that** it includes steps of:
providing a substrate (21) including a first layer of insulating material (34) on an upper surface;
depositing a layer of first conductive material (42) on an upper surface of the first layer of insulating material;
etching a first aperture (44) in the first conductive material (42);
depositing a second layer of insulating material (46) to cover an upper surface of the first conductive material (42) and to fill the first aperture;
etching a second aperture, in the second layer of insulating material (46), the second aperture covering the surface of the first aperture (44);
etching a third aperture in the first layer of insulating material (34) directly below the first aperture (44);
depositing a thin layer (58) of material over an upper surface of the structure, including the internal surfaces of the apertures;
filling the apertures with a second conductive material (60) ;
etching the thin layer material (58) until its upper surface is disposed below a lower surface of the layer of first conductive material (42); and
depositing a sealing layer (66) over the structure, wherein the sealing layer does not occupy the etched portion of the thin layer (58).

17. The method according to claim 16, further including a step of depositing below the first layer of insulating material (34) a third layer (38) that supports the overvoltage protection structure, the first and second layer of insulating material being selectively etchable with respect to said third layer.

18. The method according to claim 17, wherein the third layer (38) is made of polysilicon.

19. The method according to claim 16, wherein the thin layer (58) has a thichness in a range between 10 nm and 90 nm.

20. The method according to claim 19, wherein the thin layer (58) is a composite layer of titanium and titanium nitride.
